# EUROPEAN PATENT APPLICATION

(11) **EP 0 967 667 A2**
(43) Date of publication of application: **29.12.1999**
(21) Application number: 99304820.6
(22) Date of filing: 18.06.1999
(51) Int. Cl.: H01L 51/20, H01L 51/40, C23C 14/24, C23C 14/12

(54) **Apparatus and method for preparing organic el device**

(30) Priority: 23.06.1998 JP 19235898
(71) Applicant: TDK Corporation, Chuo-ku, Tokyo 103-8272 (JP)
(72) Inventor: Tanabe, Hiroshi, c/o TDK Corporation, Tokyo, 103-8272 (JP); Tokura, Satoshi, c/o TDK Corporation, Tokyo, 103-8272 (JP); Fukuyu, Kengo, c/o TDK Corporation, Tokyo, 103-8272 (JP); Horita, Akihiro, c/o TDK Corporation, Tokyo, 103-8272 (JP); Koishi, Masaaki, c/o TDK Corporation, Tokyo, 103-8272 (JP); Sasaki, Toru, c/o TDK Corporation, Tokyo, 103-8272 (JP)
(74) Representative: Sarup, David Alexander

(57) **Abstract**

An apparatus for preparing an organic EL device includes a substrate (1) and an evaporation source (2) in an evaporation chamber. The evaporation source (2) has a container (2) made of an insulator with a thermal conductivity of at least 50 W/m·k and receiving a source material therein and a surrounding resistance heater (3). When the source material is heated and evaporated from the source onto the substrate, a detector (5) detects the rate of evaporation of the source material on the substrate and delivers a detection signal to a control unit (6), which controls the heater (3) in accordance with the signal.

## Description

This invention relates to an apparatus and method for preparing an organic electroluminescent (EL) device, and more particularly, to an apparatus and method for preparing an organic EL device using an evaporation process of heating and evaporating an organic source material, thereby depositing the material on a selected region of a substrate to form a thin film thereon.

### BACKGROUND OF THE INVENTION

Vacuum evaporation is well known as one of basic thin-film forming processes. In the vacuum evaporation process, an evaporation source and a substrate are placed in a vacuum chamber, and the evaporation source is evaporated to deposit a thin film on the substrate. A variety of evaporation sources are known. One typical process is a resistance heating evaporation process of conducting electric current across a metal container or boat having a relatively high electric resistance to generate heat with which a source material is evaporated, as described in Appl. Phys. Lett., 68 (16), pp. 2276-2278, 15 April 1996, for example. Also known is an electron beam/laser beam evaporation process of directly irradiating electron beams or laser beams to a source material for evaporating the material with the beam energy. Of these, the resistance heating evaporation process is widely used in the art because the deposition apparatus is of simple construction so that thin films of quality can be formed at a low cost.

In the resistance heating evaporation process, a metal material having a high melting point such as tungsten, tantalum or molybdenum is worked into a thin plate having a high electric resistance, from which a container or boat is made. A source material is placed in the container, which is disposed in a (vacuum) chamber. Direct current is conducted across the container to generate heat, with which the source material is evaporated to feed a source material gas. A part of the dispersing gas deposits on the substrate to form a thin film. As the source material to be evaporated, any of materials having a relatively high vapor pressure may be used although the material that is chemically reactive with the container should be avoided.

In case organic EL displays are manufactured using the evaporation process, it is crucial for commercial mass-scale manufacture to increase the productivity and to reduce the percent rejection. Specifically, it was difficult to attain the uniformity of products because of non-uniformity in thickness and composition of organic layers during the manufacturing process. When a functional thin film such as an electron injecting electrode is deposited on the organic layer, the organic layer can be damaged or inversely, the electron injecting electrode itself be contaminated with impurities or oxidized. These lead to defectives such as non-uniform luminance, dot defects, and current leakage as well as quality variances.

Few of these problems arise with the evaporation boat since direct resistance heating is possible so that the rate of evaporation is easily controllable. The boat, however, can accommodate therein only a small amount of a source material, lacking a practical utility from the industrial aspect.

On the other hand, a cell type evaporation source can contain a larger amount of source material, but is low in thermal response because of indirect heating. As a consequence, it is difficult to control the rate of evaporation. The percent utilization of the source material becomes low when the rate of evaporation is set constant. This makes it difficult to reduce the cost of products particularly when an expensive organic material is used. Also, in the case of evaporation at a relatively low temperature from the cell type evaporation source as in the deposition of organic layers in organic EL devices, the thermal response is further exacerbated because of poor radiating efficiency.

In particular, light emitting layers of organic EL devices are often formed by doping a host material with a minor amount of fluorescent material so as to adjust to the desired luminous characteristics. Even a slight shift in the amount of host material or dopant in the mixed layer can jeopardize the luminous characteristics.

### SUMMARY OF THE INVENTION

An advantage of the invention in its preferred embodiments is to provide an apparatus and method for the preparation of an organic EL device which uses an evaporation source capable of containing a large amount of source material, enables stable evaporation over a long period of time, enables to adjust and maintain uniform the thickness and composition of a thin film, and allows for evaporation at relatively low temperatures or on a substrate with a relatively large surface area.

Another advantage of the invention in its preferred embodiments is to provide an apparatus and method for the preparation of an organic EL device which can control at high precision the mixing ratio or doping amount in multi-source evaporation.

In a first aspect, the invention provides an apparatus for preparing an organic electroluminescent (EL) device, comprising a substrate on which the organic EL device is to be formed, an evaporation source including a container made of an insulator with a thermal conductivity of at least 50 W/m·k and having a source material received therein and a heater closely surrounding the container for heating the source material for evaporating it, a means for detecting the rate of evaporation of the source material on the substrate, and a means for controlling the evaporation source in accordance with information from the detecting means.

In preferred embodiments, the control means controls so as to keep the evaporation rate constant; the control means controls the temperature of the evaporation source; the control means controls the electric current or power applied to the heater of the evaporation source. In a further preferred embodiment, the control means controls the temperature of the evaporation source and then controls so as to keep the evaporation rate constant.

The source material is preferably an organic material which evaporates at a temperature of up to 800°C.

The heater is preferably surrounded by a layer of an insulator having a thermal conductivity of at least 50 W/m·k. Typically, the insulator of the container or the insulator of the surrounding layer or both are pyrolytic boron nitride, and the heater comprises carbon.

Preferably, the evaporation source has a gas cooling system which is shielded from the ambience of an evaporating chamber where the substrate, the evaporation source and the detecting means are located. The gas cooling system preferably uses a gas coolant having a thermal conductivity of greater than 0.015 W/m·k.

In another aspect, the invention provides a method for preparing an organic electroluminescent device on a substrate, using an evaporation source including a container made of an insulator with a thermal conductivity of at least 50 W/m·k and having a source material received therein and a heater closely surrounding the container for heating the source material for evaporating it. The method involves the steps of actuating the heater for heating and evaporating the source material, detecting the rate of evaporation of the source material on the substrate to acquire information, and controlling the evaporation source in accordance with the information, thereby depositing the source material on the substrate.

In preferred embodiments, the controlling step is to keep the evaporation rate constant; the controlling step is to control the temperature of the evaporation source; the controlling step is to control the temperature of the evaporation source by stepwise preheating; the controlling step is to control the electric current or power applied to the heater of the evaporation source. In a further preferred embodiment, the controlling step includes controlling the temperature of the evaporation source and then controlling so as to keep the evaporation rate constant. The source material is typically an organic material which evaporates at a temperature of up to 800°C. The method may further involve the step of cooling the evaporation source by a gas cooling system which is shielded from the ambience of an evaporating chamber.

### BRIEF DESCRIPTION OF THE DRAWINGS

These and other features and advantages of the invention will be better understood by reading the following description, taken in conjunction with the accompanying drawings.

FIG. 1 schematically illustrates one exemplary arrangement of the apparatus of the invention.

FIG. 2 is a cross-sectional view of the evaporation source in the apparatus.

FIG. 3 is a graph showing how to control with time the temperature of an evaporation source and the evaporation rate in one example of the invention.

FIG. 4 is a graph showing how to control with time the temperature of an evaporation source and the evaporation rate in another example of the invention.

FIG. 5 is a graph showing how to control with time the temperature of an evaporation source and the evaporation rate in a further example of the invention.

### DESCRIPTION OF THE PREFERRED EMBODIMENTS

The apparatus for preparing an organic EL device according to the invention includes a substrate on which the organic EL device is to be formed, an evaporation source from which a source material is evaporated, a means for detecting the rate of evaporation of the source material on the substrate, and a means for controlling the evaporation source. The substrate, the evaporation source, and the detecting means are typically disposed within a vacuum chamber. The evaporation source includes a container made of an insulator having a thermal conductivity of at least 50 W/m·k, with the source material received in the container, and a resistance heater closely surrounding the container for heating the source material for evaporating it. The control means controls the evaporation source in accordance with information from the detecting means.

Since the container of the evaporation source is formed from an insulator having a thermal conductivity of at least 50 W/m·k and closely surrounded by the heater, the evaporation source has a very good thermal response and is adapted for the control of the evaporation rate. The detecting means detects an evaporation rate of the source material. By controlling the evaporation source in accordance with the information representative of the evaporation rate delivered from the detecting means, a thin film having a uniform thickness and composition can be deposited.

The container of the evaporation source is formed from an insulator having a thermal conductivity of at least 50 W/m·k, preferably at least 75 W/m·k, more preferably at least 100 W/m·k, most preferably at least 125 W/m·k. The upper limit of thermal conductivity is not critical although it is usually about 300 W/m·k. Exemplary insulators having such a thermal conductivity include aluminum nitride, boron nitride, and pyrolytic boron nitride (PBN), with the PBN being preferred. Pyrolytic boron nitride may be formed by CVD or other processes. Whether or not boron nitride is pyrolytic can be determined by an analysis of crystal structure by x-ray diffractometry (XRD). Specifically, in the case of pyrolytic boron nitride, a peak of the [002] face is mainly detected in XRD among hexagonal BN crystal orientations, and its intensity is outstandingly greater than those of other faces such as [100], [101], [102], and [001], which is different from the x-ray peaks of other hexagonal BN. Pyrolytic boron nitride has the composition of boron nitride, but may somewhat deviate from the stoichiometry.

The dimensions of the evaporation source may be determined as appropriate depending on the scale of the overall system and the size of a substrate on which a material is to be evaporated. When the container is a cylindrical crucible, its diameter (inner diameter) is usually about 5 to 50 mm and preferably about 5 to 30 mm for reducing the temperature distribution within the crucible. The depth is about 20 to 200 mm. The wall gage is usually about 0.3 to 5.0 mm and preferably about 0.5 to 2 mm when the breakage resistance and heat transfer of the container are taken into account.

Preferably the evaporation source has a gas cooling system which is shielded from the ambience of the evaporating chamber. The gas cooling system provides an improved cooling effect, with which the thermal response rate is increased. This embodiment is effective especially for the low-temperature evaporation of organic materials. One exemplary cooling system includes a jacket disposed outside the evaporation source container with the heater integrally formed therewith so as to define a space between the container and the jacket wherein a gas coolant is circulated through the space. The jacket is tightly joined to the container using O-rings or other sealing members. The cooling system is sealed in this way in order to maintain the vacuum within the evaporating chamber.

The gas coolant is preferably a gas having a predetermined thermal conductivity, least reactivity with the cell, and ease of handling. Specifically, the coolant gas preferably has a thermal conductivity of at least 0.015 W/m·k, more preferably at least 0.025 W/m·k, and most preferably at least 0.15 W/m·k. Examples of the coolant gas include inert gases such as He, Ne and Ar and least reactive gases such as nitrogen (N₂). Helium and nitrogen gases are preferred among others. A mixture of two or more of these gases is also useful while the mixing ratio is arbitrary.

The flow rate of the gas coolant varies with the heat capacity of the evaporation source, the heat release value of the heater, etc. although it is usually about 50 to 5,000 SCCM. The manner of controlling the flow rate is not critical although a mass flow control mode is preferable. The direction of gas coolant flow is typically upward.

Several requirements are imposed on the evaporation source. It is required that (1) precise and steady temperature control is possible, (2) the deposition rate is high enough to accommodate mass production, (3) the container can receive a sufficient amount of source material to cover large size substrates, (4) the container is not chemically reactive with constituent materials of organic EL devices, and (5) a source material can be evaporated to a desired vapor state and diffused in a stable manner. Of these, requirements (1) and (2) are already discussed. As long as the above-described materials satisfying these requirements are used, the shape of the evaporation source is not particularly limited and the evaporation source of any desired shape may be used. One preferred evaporation source is a Knudsen cell. The Knudsen cell is a cell having a predetermined opening as a vapor effusion port. Provided that the opening has a diameter d and a thickness t, the distribution of vapor density exiting from the effusion port takes the shape of a candle flame and is approximated by cosⁿθ. The n value is given by the approximation that the ratio of a vapor density m at an arbitrary position to the vapor density m0 at the center, m/m0 ∝ cosⁿθ. As d/t decreases, the n value increases and the shape of a flame becomes acute. In case of t = 0 at the extremity, n = 1 resulting in a spherical distribution standing on the opening. This corresponds to the evaporation from an open liquid surface and is known as Langmuir evaporation. Preferably n has a value of 3 to 5.

Also preferably, the evaporation source is disposed relative to the substrate such that the angle between a line connecting the center of the opening of the evaporation source and the center of the substrate and the surface of the substrate is from 20° to 60° , preferably from 30° to 60° . By effecting evaporation from an oblique direction with respect to the substrate surface, step coverage is improved. Then an organic layer is formed so as to cover any contaminant or foreign particle on a substrate (or a hole injecting electrode or in the case of a reversely stacked structure, an electron injecting electrode), avoiding the occurrence of current leakage. Additionally, the electron injecting electrode such as a metal thin film or the hole injecting electrode such as ITO is improved in film physical properties. If the angle between the line connecting the centers of the evaporation source opening and the substrate and the substrate surface is more than 60° , step coverage is aggravated. Another problem associated with an angle of more than 60° is that as the substrate size increases, the distance between the evaporation source and the substrate must be increased in order to achieve a uniform film thickness distribution, which results in a lower deposition rate. If the angle is less than 20° , the film thickness distribution becomes non-uniform and the distance between the substrate and the evaporation source must be increased along an extension line of that angle in order to achieve a uniform film thickness distribution, which undesirably requires an apparatus of greater size beyond the practically acceptable size.

Understandably, the substrate may be inclined relative to a horizontal plane. In this case, the angular relationship between the substrate and the evaporation source is maintained the same as above. The angle of the substrate relative to the horizontal plane is usually from 0° to 60° although it is not particularly limited insofar as the angle between the substrate and the evaporation source falls within the above-defined range. As long as the above requirements are met, the substrate may be stationary or rotating. Rotation of the substrate further improves step coverage and allows a film of uniform quality and thickness distribution to deposit.

A too close distance between the substrate and the evaporation source tends to obstruct uniform evaporation over the entire surface of the substrate whereas a too long distance tends to lower the deposition rate. Then, the distance between the substrate and the evaporation source, that is, the minimum distance between the horizontal plane where the center of the opening of the evaporation source is located and the horizontal plane where the center of the substrate is located is preferably 1.0 to 3.0 times, more preferably 1.5 to 2.5 times the distance between the center and the edge of the substrate. A plurality of evaporation sources may be arranged concentrically about the substrate center, all within the above range of substrate-to-source distance. In this case, co-evaporation may be effected.

Around the container of the evaporation source is closely arranged the resistance heater. The heater is not critical as long as it can be formed in close contact with the outer periphery of the evaporation source container. For example, graphite is directly deposited on the container to form a thin film thereof, or a film heater comprising polyimide and stainless steel foils is attached to the container. Of these, the graphite thin film directly deposited on the container is preferred because of a good thermal response. The graphite used herein may be pyrolytic graphite. The pyrolytic graphite can be formed by CVD or other processes. The pyrolytic graphite by CVD is more firmly and closely joined to the container. It is recommended that the heater is, in turn, surrounded by a layer of an insulator having a thermal conductivity of at least 50 W/m·k. The provision of the outside insulator layer ensures insulation and improves the inward heat transfer from the heater. The preferred insulators used herein are the same as the above-mentioned insulators, especially PBN.

The heat release value of the heater may be determined as appropriate depending on the dimensions of the evaporation source, the type of source material, the area to be covered, etc. Usually, an input power of about 50 to 500 W is applied to the heater while the heater has a resistance per unit length of about 3 to 3,000 Ω.

The means for detecting the rate of evaporation of the source material is not critical insofar as it can detect a time series change of the amount of source material depositing on the substrate. A choice may be made among well-known evaporation rate detectors. Illustratively, a detector is combined with an oscillator (e.g., of quartz) such that a source material deposited on the oscillator is detectable as a change of natural oscillation of the oscillator.

A signal or information representative of the evaporation rate detected by the evaporation rate detector is delivered to the control means. Based on the signal or information representative of the evaporation rate from the evaporation rate detector, the control means controls the evaporation source so as to maintain the evaporation rate constant. To this end, the control means directly controls the electric current or power applied to the heater of the evaporation source. If a temperature control system is built in the existing evaporation apparatus or available as an off-the-shelf product, the control means cooperates with the temperature control system so as to achieve the predetermined temperature.

The desired range within which the evaporation rate is to be controlled varies with the type of source material, etc. For organic materials of organic EL devices, the evaporation rate is desirably in the range of 0.05 to 0.6 nm/sec, more desirably 0.1 to 0.5 nm/sec, most desirably 0.3 to 0.5 nm/sec, as measured at a height straight above the opening of the evaporation source and corresponding to the position of the substrate. It is noted that if the source material is a mixture of a host material and a dopant, the evaporation rate of the host material is usually in the above range while the evaporation rate of the dopant is in a range of 0.1 to 10% of the evaporation rate of the host material.

The source material to be evaporated is not critical insofar as it is a constituent material of organic EL devices. It is preferred that the evaporating temperature of the source material that is equal to the temperature of the evaporation source during evaporation is up to 800°C, preferably up to 500°C. The lower limit is not critical although it is usually about 150°C. Of these source materials, organic materials used in light emitting layers to be described later are especially preferred. This is because such organic materials are evaporated at relatively low temperatures and a slight change of the dose or mixing amount of a dopant has a significant influence on the device characteristics. Therefore, the present invention is effective particularly when accurate control of evaporating amounts is requisite as in the case of multi-source evaporation of organic materials.

The main control means is not particularly limited in construction insofar as it can analyze the information delivered from the evaporation rate detecting means and carry out heater control in accordance therewith. The control means is usually a general-purpose microprocessor (MPU) which is combined with a storage medium (ROM, RAM, etc.) bearing a control algorithm. Any of microprocessors including CISC, RISC, and DSP may be used as the control means. Besides, the control means may be constructed by ASIC, a combination of logic circuits by common ICs, or an analog arithmetic circuit using an operational amplifier.

The substrate used herein is not critical as long as an organic EL device can be stacked thereon. Where emitted light exits from the substrate side, transparent or translucent materials such as glass, quartz and resins are employed. The substrate may be provided with a color filter film, a fluorescent material-containing color conversion film or a dielectric reflecting film for controlling the color of light emission. Where emitted light exits from the side opposite to the substrate, the substrate may be either transparent or opaque. Ceramics may be employed as the opaque substrates.

The size of the substrate is not critical. Preferably, the substrate has a maximum length of about 200 to about 700 mm, especially about 400 to about 700 mm, which is a diagonal length for a typical rectangular substrate. Although a maximum length of less than 200 mm is not a problem, the advantage of the invention that a uniform film thickness distribution is accomplished even on substrates of larger size becomes outstanding with a maximum length of more than 200 mm. However, a substrate size in excess of 700 mm would give rise to problems including a larger size of film forming apparatus, low deposition efficiency, and difficulty of film thickness control.

The apparatus of the invention is capable of precision control of the evaporation rates of source materials located at different radial positions, thereby controlling the film thickness. More particularly, by arranging a plurality of evaporation sources at concentric circles having different radii and accurately controlling the evaporation rates of these evaporation sources to the predetermined values, the thickness distribution of a film on a large size substrate is improved.

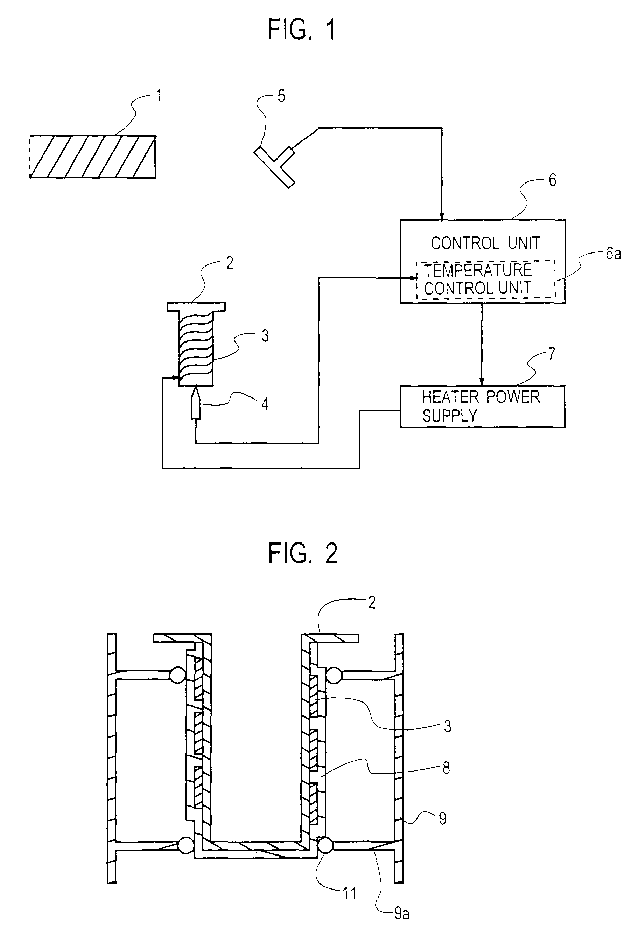

Referring to FIGS. 1 and 2, the construction of the apparatus of the invention is illustrated in more detail.

FIG. 1 is a schematic view showing the basic construction of the apparatus for producing organic EL devices according to the invention. The apparatus includes a substrate 1 (only a part thereof is shown), an evaporation source 2, an evaporation rate detector 5, a control unit 6, and a heater power supply 7 coupled with the control unit 6. The evaporation source includes a container 2 and a heater 3 formed or mounted closely on the container 2 and connected to the power supply 7. A temperature sensor 4 is associated with the evaporation source 2 for detecting the temperature of the source. The detector 5 and the sensor 4 are coupled to the control unit 6 so that the control unit 6 receives a signal representative of the evaporation rate detected by the detector 5 and a signal representative of the source temperature detected by the sensor 4. The control unit 6 includes a temperature control unit 6a which functions to control the power supply 7 on the basis of the temperature data detected by the sensor 4, so that the temperature of the evaporation source may become the predetermined value (or present temperature). The power supply 7 supplies a controlled electric current or power to the heater 3 to generate the necessary heat.

The evaporation source 2 may be constructed as shown in FIG. 2. The evaporation source 2 in the illustrated embodiment includes the generally cylindrical container or main body 2, the heater 3 formed closely thereon, and an insulating coating 8 formed on the heater 3. A jacket 9 having flanges 9a is disposed around and spaced from the evaporation source 2. The jacket 9 is fitted on the evaporation source 2 via flanges 9a and O-rings 11 in a fluid tight manner. A space is defined between the jacket 9 and the evaporation source 2. A coolant gas is fed and circulated through the space for cooling the evaporation source 2.

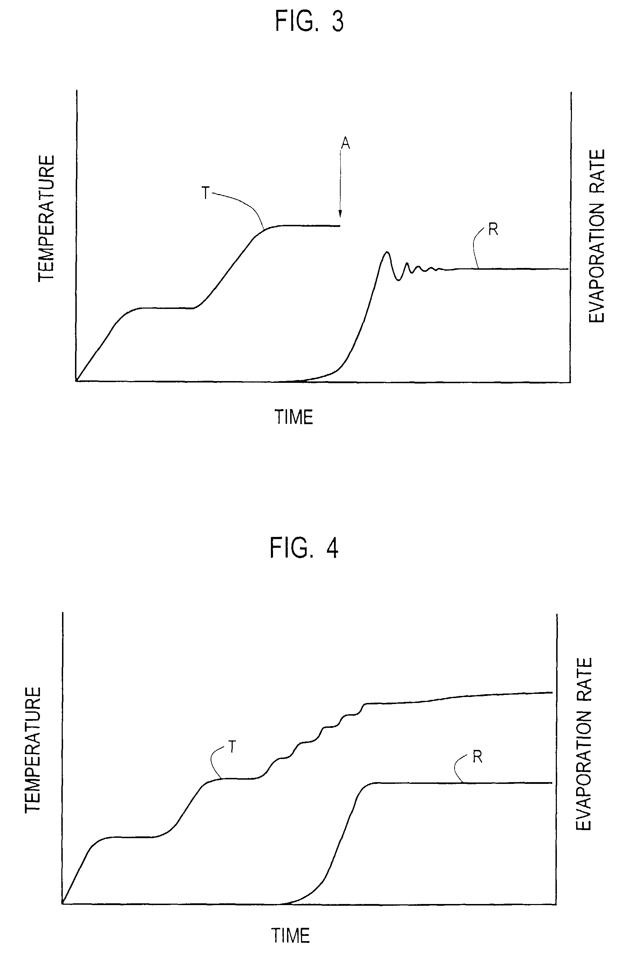

In the apparatus thus constructed, the temperature of the evaporation source is controlled at the start of evaporation as shown in FIG. 3. More particularly, the control unit 6, specifically the temperature control unit 6a controls the power supply 7 such that the evaporation source 2 is heated until the predetermined value (or present temperature) is reached. The temperature T of the evaporation source rises as shown by the left curve in the graph of FIG. 3.

When the temperature T of the evaporation source reaches stable point A of the predetermined value, the control unit 6 changes over its control mode from the temperature control to the evaporation rate control. Switching from the control by the temperature control unit 6a, the control unit 6 now directly controls the power supply 7 so as to provide the predetermined evaporation rate. The evaporation rate R rises further and stabilizes at the predetermined value. In this way, the source temperature is controlled before the start of evaporation and once the evaporating temperature reaches the predetermined value, the evaporation rate is controlled. As a consequence, the rise time of evaporation rate becomes short, the hunting phenomenon and fluctuation or variation of deposition rate are suppressed, and stable evaporation takes place. The thin film thus deposited becomes uniform in quality and thickness.

In the above embodiment, dual shutters are provided between the evaporation source and the substrate, one straight above the evaporation source and one immediately below the substrate. The shutter on the evaporation source side is opened at the start of measurement of the evaporation rate, and the shutter on the substrate side is opened at the start of deposition after the evaporation rate is stabilized. Then the source material starts to deposit on the substrate after the evaporation rate is stabilized. The invention thus achieves film deposition and control at high precision.

In the graph of FIG. 3, the temperature T of the evaporation source is increased stepwise. Stepwise heating is a kind of preheating also known as soaking which is generally intended for drying and is effective herein for the evaporation of organic materials. By carrying out initial heating under temperature control, effective soaking is achieved.

The temperature control unit 6a may be constructed such that it may operate either as a part of the control unit 6 (in hardware or software) or independently of the control unit 6. When a conventional temperature control unit is used in its original state, it may be controlled as a unit separate and independent from the control unit 6. The temperature control unit 6a is not particularly limited insofar as it can carry out appropriate temperature control. For example, a hardware (analog or digital circuit) to which the proportional integral differential (PID) control mode is applied or a control algorithm having the mode extended may be used.

The temperature sensor may be selected from well-known temperature sensors. A sensor capable of precise detection at the evaporating temperature of source materials is recommended. The range of temperature to be measured is usually from about 20°C to about 800°C although it varies with the properties of source material. The temperature sensors useful in such application include thermocouples, platinum thermometers and thermistors.

FIG. 4 illustrates a second embodiment of the invention. In this embodiment, the evaporation rate is controlled at the predetermined value by controlling the temperature throughout the process. The control of the evaporation rate based on consistent temperature control eliminates the hunting phenomenon of the deposition rate which can occur in the control mode shown in FIG. 3. More illustratively, in the initial heating stage, temperature control is carried out as in FIG. 3 until the predetermined temperature is reached. In this stage too, soaking as shown in the graph is carried out, if desired.

Next, the control unit 6 carries out further heating through the temperature control unit 6a. By monitoring the deposition rate at intervals, the temperature control unit 6a (for setting the heating temperature) is controlled so that the deposition rate may become the predetermined (or preset) value. As in the first embodiment, dual shutters provided between the evaporation source and the substrate are similarly operated. By controlling the evaporation rate by way of temperature control even after the temperature of the evaporation source 2 reaches the predetermined value, the hunting phenomenon and fluctuation or variation associated with the rise of the deposition rate can be suppressed and minimized.

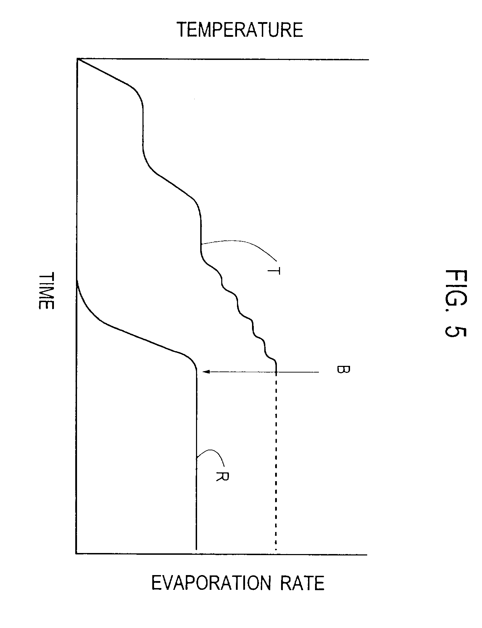

In the control mode of FIG. 4 wherein temperature control is carried out, after the predetermined deposition rate is reached, so as to keep the evaporation rate constant, it is sometimes difficult to keep the deposition rate constant. To avoid the instability of control, a control mode as shown in FIG. 5 is effective.

FIG. 5 illustrates a third embodiment of the invention. In this embodiment, temperature control is carried out until the predetermined evaporation rate is reached, while monitoring the evaporation rate R as in the embodiment of FIG. 4. Thereafter, the control mode is changed over to the mode of directly controlling the heater power supply 7 in accordance with the evaporation rate as in the embodiment of FIG. 3. That is, the control unit 6 carries out temperature control until the evaporation rate R reaches the predetermined value, as in the embodiment of FIG. 4, and after the evaporation rate R reaches the predetermined value B, the control unit 6 carries out control to maintain the evaporation rate R at the predetermined value B, by controlling the heater power supply 7 directly and not by way of the temperature control unit 6a, for controlling the electric current or power to the heater 3. This embodiment is effective for restraining the temperature T from rising after the evaporation rate is stabilized, which can occur in the embodiment of FIG. 4.

Although several control modes using the apparatus of the invention have been described, an optimum one may be selected from them by taking into account the type of source material, the size of the apparatus and other factors.

The invention allows for heating control with a quick temperature rise, adequate soaking, and stable control of evaporation rate and thus enables to form an evaporated thin film of uniform quality and thickness which is difficult to form by prior art evaporation processes. The invention is thus effective in forming a functional thin film by evaporating an organic material, especially a light emitting layer of organic EL devices. The invention also enables to accurately adjust and maintain the mixing quantities of two or more organic materials or the doping quantity in two or multi-source evaporation. Organic EL devices having consistent luminous performance can be prepared in a mass-scale manufacture process.

Thin films of organic EL devices which can be formed by the apparatus of the invention include a hole injecting and transporting layer, light emitting layer, and electron injecting and transporting layer. The invention is also effective for improving film physical properties between an electrode and an organic layer as previously mentioned. Therefore, the invention is continuously applicable in forming a hole injecting electrode or electron injecting electrode.

The organic layers which can be formed according to the invention are illustrated below.

The light emitting layer contains a fluorescent material that is a compound having a light emitting capability. The fluorescent material may be at least one member selected from compounds as disclosed, for example, in JP-A 63-264692, such as quinacridone, rubrene, and styryl dyes. Also, quinoline derivatives such as metal complex dyes having 8-quinolinol or a derivative thereof as the ligand such as tris(8-quinolinolato)aluminum are included as well as tetraphenylbutadiene, anthracene, perylene, coronene, and 12-phthaloperinone derivatives. Further useful are the phenylanthracene derivatives described in JP-A 8-12600 and the tetraarylethene derivatives described in JP-A 8-12969.

It is preferred to use the fluorescent material in combination with a host material capable of light emission by itself, that is, to use the fluorescent material as a dopant. In this embodiment, the content of the fluorescent material in the light emitting layer is preferably 0.01 to 10% by weight, especially 0.1 to 5% by weight. By using the fluorescent material in combination with the host material, the light emission wavelength of the host material can be altered, allowing light emission to be shifted to a longer wavelength and improving the luminous efficacy and stability of the device.

As the host material, quinolinolato complexes are preferable, with aluminum complexes having 8-quinolinol or a derivative thereof as the ligand being more preferable. These aluminum complexes are disclosed in JP-A 63-264692, 3-255190, 5-70733, 5-258859 and 6-215874.

Illustrative examples include tris(8-quinolinolato)-aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolatoaluminum, tris(5,7-dibromo-8-hydroxyquinolinolato)aluminum, and poly[zinc(II)-bis(8-hydroxy-5-quinolinyl)methane].

Also useful are aluminum complexes having another ligand in addition to 8-quinolinol or a derivative thereof. Examples include bis(2-methyl-8-quinolinolato)(phenolato)-aluminum(III), bis(2-methyl-8-quinolinolato)(ortho-cresolato)aluminum(III), bis(2-methyl-8-quinolinolato)-(meta-cresolato)aluminum(III), bis(2-methyl-8-quinolinolato)(para-cresolato)aluminum(III), bis(2-methyl-8-quinolinolato)(ortho-phenylphenolato)aluminum(III), bis(2-methyl-8-quinolinolato)(meta-phenylphenolato)-aluminum(III), bis(2-methyl-8-quinolinolato)(para-phenylphenolato)aluminum(III), bis(2-methyl-8-quinolinolato)(2,3-dimethylphenolato)aluminum(III), bis(2-methyl-8-quinolinolato)(2,6-dimethylphenolato)aluminum(III), bis(2-methyl-8-quinolinolato)(3,4-dimethylphenolato)aluminum(III), bis(2-methyl-8-quinolinolato)(3,5-dimethylphenolato)aluminum(III), bis(2-methyl-8-quinolinolato)(3,5-di-tert-butylphenolato)aluminum(III), bis(2-methyl-8-quinolinolato)(2,6-diphenylphenolato)aluminum(III), bis(2-methyl-8-quinolinolato)(2,4,6-triphenylphenolato)aluminum(III), bis(2-methyl-8-quinolinolato)(2,3,6-trimethylphenolato)aluminum(III), bis(2-methyl-8-quinolinolato)(2,3,5,6-tetramethylphenolato)aluminum(III), bis(2-methyl-8-quinolinolato)(1-naphtholato)aluminum(III), bis(2-methyl-8-quinolinolato)(2-naphtholato)aluminum(III), bis(2,4-dimethyl-8-quinolinolato)(ortho-phenylphenolato)aluminum(III), bis(2,4-dimethyl-8-quinolinolato)(para-phenylphenolato)aluminum(III), bis(2,4-dimethyl-8-quinolinolato)(metaphenylphenolato)aluminum(III), bis(2,4-dimethyl-8-quinolinolato)(3,5-dimethylphenolato)aluminum(III), bis(2,4-dimethyl-8-quinolinolato)(3,5-di-tert-butylphenolato)aluminum(III), bis(2-methyl-4-ethyl-8-quinolinolato)(para-cresolato)aluminum(III), bis(2-methyl-4-methoxy-8-quinolinolato)(para-phenylphenolato)aluminum(III), bis(2-methyl-5-cyano-8-quinolinolato)(orthocresolato)aluminum(III), and bis(2-methyl-6-trifluoromethyl-8-quinolinolato)(2-naphtholato)aluminum(III).

Also acceptable are bis(2-methyl-8-quinolinolato)aluminum(III)-p-oxo-bis(2-methyl-8-quinolinolato)aluminum (III), bis(2,4-dimethyl-8-quinolinolato)aluminum(III)-p-oxo-bis(2,4-dimethyl-8-quinolinolato)aluminum(III), bis(4-ethyl-2-methyl-8-quinolinolato)aluminum(III)-µ-oxo-bis(4-ethyl-2-methyl-8-quinolinolato)aluminum(III), bis(2-methyl-4-methoxyquinolinolato)aluminum(III)-µ-oxo-bis(2-methyl-4-methoxyquinolinolato)aluminum(III), bis(5-cyano-2-methyl-8-quinolinolato)aluminum(III)-p-oxo-bis(5-cyano-2-methyl-8-quinolinolato)aluminum(III), and bis(2-methyl-5-trifluoromethyl-8-quinolinolato)aluminum(III)-µ-oxo-bis(2-methyl-5-trifluoromethyl-8-quinolinolato)aluminum (III).

Other useful host materials are the phenylanthracene derivatives described in JP-A 8-12600 and the tetraarylethene derivatives described in JP-A 8-12969.

The light emitting layer may also serve as the electron injecting and transporting layer. In this case, tris(8-quinolinolato)aluminum etc. are preferably used.

The electron injecting and transporting compound is preferably selected from quinoline derivatives and metal complexes having 8-quinolinol or a derivative thereof as a ligand, especially tris(8-quinolinolato)aluminum (Alq3). The aforementioned phenylanthracene derivatives and tetraarylethene derivatives are also preferable.

The compound for the hole injecting and transporting layer is preferably selected from amine derivatives having strong fluorescence, for example, triphenyldiamine derivatives, styrylamine derivatives and amine derivatives having an aromatic fused ring.

The electron injecting electrode is preferably formed from materials having a low work function, for example, metal elements such as K, Li, Na, Mg, La, Ce, Ca, Sr, Ba, Al, Ag, In, Sn, Zn, and Zr, and binary or ternary alloys made of two or three such metal elements for stability improvement. Exemplary alloys are Ag-Mg (Ag: 0.1 to 50 at%), Al-Li (Li: 0.01 to 12 at%), In-Mg (Mg: 50 to 80 at%), and Al-Ca (Ca: 0.01 to 20 at%). It is understood that the electron injecting electrode can also be formed by evaporation or sputtering.

The electron injecting electrode thin film may have a sufficient thickness for electron injection, for example, a thickness of at least 0.1 nm, preferably at least 1 nm. Although the upper limit is not critical, the electrode thickness is typically about 1 to about 500 nm. On the electron injecting electrode, a protective electrode may be provided, if desired.

A protective layer may be formed using metal materials, inorganic materials such as SiOx, and organic materials such as Teflon.

During evaporation, an appropriate pressure is 1x10⁻⁸ to 1x10⁻⁵ Torr and the heating temperature of the evaporation source is about 100°C to about 1,400°C for metal materials and about 100°C to about 500°C for organic materials.

The organic EL light-emitting device manufactured by the method of the invention has a hole injecting electrode on a substrate and an electron injecting electrode thereon. At least a hole transporting layer, a light emitting layer and an electron injecting and transporting layer are disposed between the electrodes. The device further has a protective electrode as the uppermost layer. Of these layers, the hole transporting layer, electron transporting layer, and protective electrode are omitted as the case may be.

A transparent or translucent electrode is preferred as the hole injecting electrode because a structure allowing emitted light to exit from the substrate side is typical. Useful materials for transparent electrodes include tin-doped indium oxide (ITO), zinc-doped indium oxide (IZO), zinc oxide (ZnO), tin oxide (SnO₂), and indium oxide (In₂O₃), with ITO and IZO being preferred. The ITO usually contains In₂O₃ and SnO in stoichiometry although the oxygen content may deviate somewhat therefrom.

The hole injecting electrode preferably has a transmittance of at least 80%, especially at least 90% for each light emission in a luminous wavelength band, typically of 350 to 800 nm. Since the emitted light exits the device through the hole injecting electrode, the hole injecting electrode with a low transmittance causes the light emission to attenuate, failing to provide a necessary luminance as the light emitting device. Where the emitted light is taken out of the device solely from one side, it suffices that the electrode on the take-out side has a transmittance of at least 80%.

The hole injecting electrode should have a sufficient thickness for hole injection and is preferably about 50 to about 500 nm thick, especially about 50 to 300 nm thick. Although no upper limit need be imposed on the thickness of the hole injecting electrode, too thick electrodes can peel off. A too thin electrode is undesirable in film strength, hole transporting capability, and resistivity.

The hole injecting electrode can be formed by evaporation or other processes although sputtering is preferable.

After the organic EL device layers are deposited, a protective film may be formed using an inorganic material such as SiOx or an organic material such as Teflon or chlorine-containing fluorocarbon polymer. The protective film may be transparent or opaque. Its thickness is typically about 50 to 1,200 nm. The protective film may be formed by reactive sputtering as well as general sputtering, evaporation and PECVD processes.

On the substrate, a color filter film, a color conversion film containing a fluorescent material, or a dielectric reflective layer may be provided for controlling the color of emitted light.

The organic EL device of the invention is generally of the dc or pulse drive type while it can be of the ac drive type. The applied voltage is generally about 2 to 30 volts.

### EXAMPLE

Examples of the present invention are given below by way of illustration and not by way of limitation.

### Example 1

The evaporation source used herein had a container which was formed from PBN into a Knudsen cell shape by CVD. A helical heater was formed on the container by depositing pyrolytic graphite by CVD. The container and heater were overcoated with PBN by CVD to form an insulative coating. The container had a thermal conductivity of 150 W/m·k and the overcoat layer had the same thermal conductivity. The container was dimensioned to a height of 75 mm, a diameter of 20 mm and a wall gage of 0.8 mm.

Using this evaporation source, there were furnished three evaporation apparatus, apparatus 1 based on the control mode of the first embodiment, apparatus 2 based on the control mode of the second embodiment, and apparatus 3 based on the control mode of the third embodiment. There was also furnished an evaporation apparatus 4 based on the control mode of the first embodiment, but by providing the evaporation source with a gas cooling system of circulating Ar gas having a thermal conductivity of 0.0179 W/m·k. For comparison purposes, apparatus were constructed so as to control the temperature of an evaporation source in the form of a prior art tantalum evaporation boat, a quartz crucible combined with an indirect heater, and a graphite crucible combined with an indirect sheath heater, designated comparative apparatus 1, 2, and 3, respectively.

Each of these apparatus was operated while charging the evaporation source container with Alq3 as a source material. Rated were evaporation rate control, evaporation rise time, evaporation fall time, material charge, and a relative material consumption.

The evaporation rate control was evaluated in three ratings, "Good" when the response was fast enough to precisely control the evaporation rate within ±5% for all organic materials, "Fair" when the response was somewhat blunt, the evaporation rate was controlled within ±20%, and a problem arose with some of organic materials requiring relatively high precision control, and "Poor" when the response was too blunt to apply to the evaporation of organic materials.

The relative material consumption is the amount of material actually deposited on the substrate divided by the amount of material lost from the evaporation source.

The results are shown in Table 1.

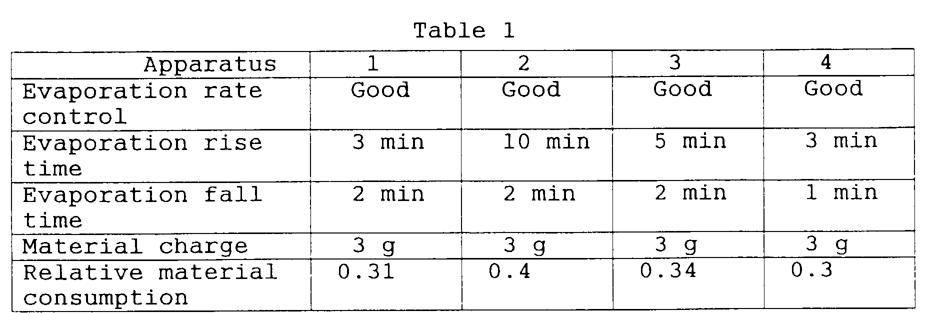

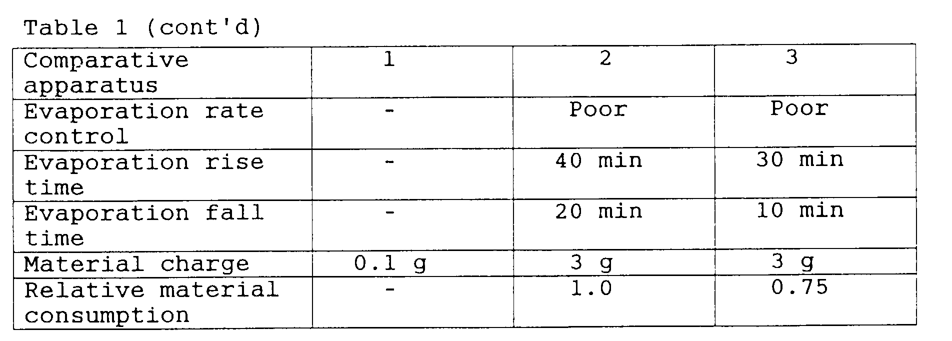

In comparative apparatus 1, evaluation was impossible because the material charge was too small.

### Example 2

Using inventive apparatus 1 in Example 1, Alq3 doped with coumarin was deposited on a substrate to form a light emitting layer. A variation of the dopant (coumarin) quantity was measured. For this measurement, thin film deposition was repeated several cycles, each cycle being from the state that the evaporation source was full of the source material to the state that the quantity of source material was reduced to the threshold above which steady evaporation was ensured. The molar ratio of Alq3 to coumarin in each of the thin films was determined, from which a variation of the dopant quantity was calculated. It is noted that control was made so as to give a dopant quantity of 1% by volume. For comparison purposes, thin film deposition was carried out using comparative apparatus 2, and a variation of the dopant quantity was determined.

The thin films deposited by means of comparative apparatus 2 showed a dopant quantity variation of ±40% whereas those of inventive apparatus 1 showed a very small dopant quantity variation of ±3%.

### Example 3

On a glass substrate, a transparent ITO electrode (or hole injecting electrode) was deposited to a thickness of 100 nm and patterned so as to define pixels in a matrix of 64 dots x 7 lines (each pixel sized 1 x 1 mm). The substrate having the patterned hole injecting electrode was subjected to ultrasonic washing with neutral detergent, acetone, and ethanol, pulled up from boiling ethanol, and dried. The surface was further cleaned with UV/ozone.

The evaporation apparatus used was inventive apparatus 1 of Example 1 by which the evaporation rate was automatically controlled. The substrate was placed in the vacuum evaporation chamber and secured by a holder. The chamber was evacuated to a vacuum of 1x10⁻⁴ Pa or lower. The evaporation source was disposed relative to the substrate such that the angle between the line connecting the center of the cell opening and the center of the substrate and the substrate surface was 20 to 60° , and the height from the evaporation source opening to the substrate surface was 500 mm.

While the substrate was rotated, 4,4',4"-tris(N-(3-methylphenyl)-N-phenylamino)triphenylamine (m-MTDATA) was evaporated at a deposition rate of 0.2 nm/sec to a thickness of 40 nm, forming a hole injecting layer. With the vacuum kept, N,N'-diphenyl-N,N'-m-tolyl-4,4'-diamino-1,1'-biphenyl (TPD) was evaporated at a deposition rate of 0.2 nm/sec to a thickness of 35 nm, forming a hole transporting layer. Then, N,N'-diphenyl-N,N'-m-tolyl-4,4'-diamino-1,1'-biphenyl (TPD) was evaporated at a deposition rate of 0.2 nm/sec to a thickness of 50 nm, while it was doped with 3% by volume of rubrene, thereby forming a light emitting layer. Further, tris(8-quinolinolato)aluminum (Alq3) was evaporated at a deposition rate of 0.2 nm/sec to a thickness of 50 nm, forming an electron injecting and transporting layer.

With the vacuum kept, Mg-Ag (Ag 10 at%) was deposited to a thickness of 200 nm, forming an electron injecting electrode.

Ten organic EL device samples were prepared in this way. They were measured for luminance by driving at a constant current density of 10 mA/cm². A variation of luminance was determined therefrom. The samples showed a luminance of about 700 cd/m², with a variation within ±35 cd/m².

### Example 4

Organic EL device samples were prepared as in Example 3 except that the organic layers were evaporated as follows.

4,4',4"-tris(N-(3-methylphenyl)-N-phenylamino)triphenylamine (m-MTDATA) was evaporated at a deposition rate of 0.2 nm/sec to a thickness of 40 nm, forming a hole injecting layer. With the vacuum kept, N,N'-diphenyl-N,N'-m-tolyl-4,4'-diamino-1,1'-biphenyl (TPD) was evaporated at a deposition rate of 0.2 nm/sec to a thickness of 35 nm, forming a hole transporting layer. Then, tris(8-quinolinolato)aluminum (Alq3) was evaporated at a deposition rate of 0.2 nm/sec to a thickness of 50 nm, while it was doped with 0.5% by volume of coumarin, thereby forming a light emitting layer. Further, tris(8-quinolinolato)aluminum (Alq3) was evaporated at a deposition rate of 0.2 nm/sec to a thickness of 50 nm, forming an electron injecting and transporting layer.

The samples showed a luminance of about 1,300 cd/m², with a variation within ±40 cd/m².

### Comparative Example 1

Organic EL device samples were prepared as in Example 3 except that the organic layers were deposited using comparative apparatus 2.

The samples showed a largely varying luminance from about 500 cd/m² to about 900 cd/m². The luminance half-life time was also found to have a large variation.

### Comparative Example 2

Organic EL device samples were prepared as in Example 4 except that the organic layers were deposited using comparative apparatus 2.

The samples showed a largely varying luminance from about 800 cd/m² to about 1,400 cd/m². The luminance half-life time was also found to have a large variation.

There have been described an organic EL device manufacturing apparatus and method which use an evaporation source capable of receiving a large amount of source material, can continue steady evaporation over a long period of time, can adjust and maintain uniform the thickness and composition of thin films deposited thereby, and are adapted for evaporation at relatively low temperatures and over a substrate of a relatively large area. The apparatus and method can control at high precision the mixing ratio or doping amount in multi-source evaporation.

Japanese Patent Application No. 10-192358 is incorporated herein by reference.

## Claims

1. An apparatus for preparing an organic electro-luminescent device comprising
a substrate on which the organic electroluminescent device is to be formed,
an evaporation source including a container made of an insulator with a thermal conductivity of at least 50 W/m·k and having a source material received therein and a heater closely surrounding the container for heating the source material for evaporating it,
a means for detecting the rate of evaporation of the source material on the substrate, and
a means for controlling said evaporation source in accordance with information from said detecting means.

2. The apparatus of claim 1 wherein said control means controls so as to keep the evaporation rate constant.

3. The apparatus of claim 1 or claim 2 wherein said control means controls the temperature of said evaporation source.

4. The apparatus of any of claims 1 to 3 wherein said control means controls the electric current or power applied to the heater of said evaporation source.

5. The apparatus of any preceding claim wherein said control means controls the temperature of said evaporation source and then controls so as to keep the evaporation rate constant.

6. The apparatus of any preceding claim wherein the source material is an organic material which evaporates at a temperature of up to 800°C.

7. The apparatus of any preceding claim wherein the insulator of said container is pyrolytic boron nitride, and said heater comprises carbon.

8. The apparatus of any preceding claim wherein said heater is surrounded by a layer of an insulator having a thermal conductivity of at least 50 W/m·k.

9. The apparatus of claim 8 wherein the insulator of said container or the insulator of the surrounding layer or both are pyrolytic boron nitride, and said heater comprises carbon.

10. The apparatus of any preceding claim wherein said evaporation source has a gas cooling system which is shielded from the ambience of an evaporating chamber.

11. The apparatus of claim 10 wherein the gas cooling system uses a gas coolant having a thermal conductivity of greater than 0.015 W/m·k.

12. A method for preparing an organic electroluminescent device on a substrate, using an evaporation source including a container made of an insulator with a thermal conductivity of at least 50 W/m·k and having a source material received therein and a heater closely surrounding the container for heating the source material for evaporating it, said method comprising the steps of:
actuating the heater for heating and evaporating the source material,
detecting the rate of evaporation of the source material on the substrate to acquire information, and
controlling said evaporation source in accordance with the information, thereby depositing the source material on the substrate.

13. The method of claim 12 wherein the controlling step is to keep the evaporation rate constant.

14. The method of claim 12 or claim 13 wherein the controlling step is to control the temperature of said evaporation source.

15. The method of claim 14 wherein the controlling step is to control the temperature of said evaporation source by stepwise preheating.

16. The method of any of claims 12 to 15 wherein said controlling step is to control the electric current or power applied to the heater of said evaporation source.

17. The method of any of claims 12 to 16 wherein said controlling step includes controlling the temperature of said evaporation source and then controlling so as to keep the evaporation rate constant.

18. The method of any of claims 12 to 17 wherein the source material is an organic material which evaporates at a temperature of up to 800°C.

19. The method of any of claims 12 to 18 further comprising the step of cooling said evaporation source by a gas cooling system which is shielded from the ambience of an evaporating chamber.
